# EUROPEAN PATENT SPECIFICATION

(11) **EP 1 557 951 B1**
(45) Date of publication and mention of the grant of the patent: **14.03.2007**
(21) Application number: 04250308.6
(22) Date of filing: 21.01.2004
(51) Int. Cl.: H03L 7/099, H03L 7/14, H04B 1/50

(54) **Frequency generator with multiple voltage-controlled oscillators**
Frequenzgenerator mit mehreren spannungsgesteuerten Oszillatoren
Générateur de fréquence avec oscillateurs multiples commandé en tension

(43) Date of publication of application: 27.07.2005
(73) Proprietor: TELEFONAKTIEBOLAGET LM ERICSSON (publ), 164 83 Stockholm (SE)
(72) Inventor: Bristow, Robert, Basingstoke RG22 5JJ (GB); Jonsson, Lars, 247 34 Södra Sandby (SE); Mattsson, Thomas, 216 14 Limhamn (SE)
(74) Representative: Vigars, Christopher Ian

(56) References cited:
- DE-A- 10 112 575
- US-A1- 2002 163 391
- US-A1- 2002 183 030
- US-B1- 6 208 875

## Description

The present invention relates to mobile telecommunications systems, and, in particular, to systems for generating reference frequency signals in mobile telecommunications systems.

### Background of the Invention

In mobile telecommunications systems of the GSM type, it is necessary to be able to transmit and receive on four common frequency bands - 850, 900, 1800 and 1900MHz. This requires frequency sources in the region of 900MHz and 1800MHz.

Typically, current frequency sources use three different voltage controlled oscillators (VCOs), operating at about 1, 2 and 4GHz. The VCOs used for transmission operate on the same frequency as the required transmit channel and the VCOs used for reception operate at twice the required receive frequency to allow use of a well known digital divider circuit to provide in-phase and quadrature local oscillator (LO) signals.

However, when implemented in an application specific integrated circuit (ASIC), the silicon area of the IC used by the 1 and 2 GHz VCOs has a significant upward impact on the cost of the ASIC. Also, there are significant problems with feedback to these VCOs since they operate at the same frequency as the transmitter signal.

In one known previously-considered example, all of the required frequencies are generated using a single VCO combined with frequency divider circuits; for example the VCO could operate in the region of 4GHz and be divided by 2 or 4 as required to provide the lower frequencies. However, this is not a straightforward technique to use in an ASIC as the required tuning range of the VCO is large.

DE 10112575 A1 discloses a circuit in which two oscillators and a set of switchable dividers allow multiple frequencies to be produced.

### Summary of the Present Invention

According to the present invention, there is provided a phase lock loop circuit for a radio frequency transmit and receive apparatus, the circuit comprising: a first voltage controlled oscillator which is operable to produce a first reference frequency signal, a second voltage controlled oscillator which is operable to produce a second reference frequency signal, a switchable set of dividers, connected to receive the first and second reference frequency signals, and operable to produce a set of output reference frequency signals therefrom, a first subset of the set of output reference frequencies being derived from the first reference frequency, and a second subset of the set of output reference frequencies being derived from the second reference frequency, and a VCO control means connected to receive an external reference signal and a feedback signal, and operable to supply a control voltage to the first and second voltage controlled oscillators in dependence upon received external reference and feedback signals, so as to maintain desired first and second reference frequency signals, wherein the first and second reference frequency signals are not equal in frequency to the output reference frequency signals in the set of output reference frequency signals, and wherein the set of dividers comprises: first divider means for receiving a reference frequency signal, and for producing a high band output reference frequency signal for a transmitter therefrom, second divider means for receiving the second reference frequency signal and for producing a low band output reference frequency signal for the transmitter, third divider means for selectively receiving the first or second reference frequency signal and for producing local oscillator output reference frequency signals for a receiver, and fourth divider means for producing a feedback signal for supply to the VCO control means.

### Brief Description of the Drawings

Figure 1 illustrates a first embodiment of the present invention;
Figure 2 illustrates a second embodiment of the present invention;
Figure 3 illustrates a third embodiment of the present invention; and
Figure 4 illustrates ranges of reference frequencies provided by VCOs used in embodiments of the present invention.

### Detailed Description of the Preferred Embodiments

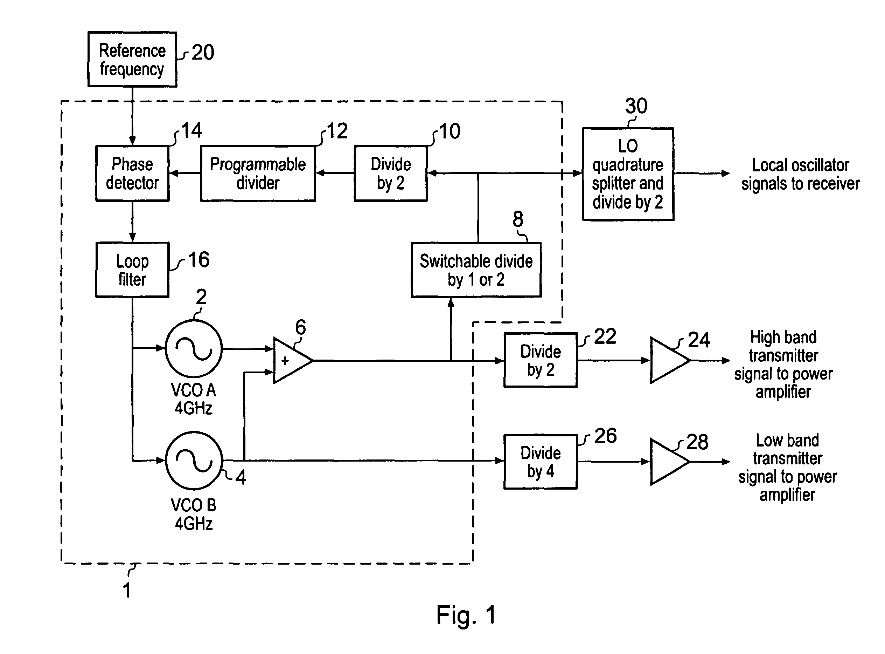

Figure 1 illustrates a first embodiment of the present invention, for providing transmitter and receiver signals suitable for use in a mobile station (MS) for use in a mobile telecommunications network. The embodiment of Figure 1 comprises a phase lock loop circuit (PLL) comprising first and second voltage controlled oscillators (VCOA, VCOB) 2 and 4. The VCOs 2 and 4 provide output signals to an adder 6 which supplies a signal to a switchable divider 8. As will be explained in more detail below, the VCOs 2 and 4 are used independently, and so the output of the adder 6 is equivalent to the output of the chosen operating VCO. The switchable divider 8 is operable to divide the signal from the adder 6 by one or two. The output of the switchable divider 8 is supplied to a further divider 10, which is operable to divide the signal by 2. The output of the divider 10 is supplied to a programmable divider 12. The programmable divider 12 supplies an output to a phase detector 14 for comparison with a reference frequency 20. The output of the phase detector 14 is supplied to a loop filter 16, which in turn supplies a filtered control signal to each of the first and second VCOs 2 and 4. The PLL operates to stabilise the outputs of the VCOs 2 and 4, in known manner. In embodiments of the present invention the VCO is operated at 2x or 4x the desired frequency, and there is always a fixed division of 2 or 4 provided by the dividers 10 and 8. This means that the frequency provided to the input of the programmable divider is the same as if the VCO were operating at the required frequency and divider 10 and 8 were not present.

The programmable divider 12 operates to lock the operating VCO to twice or four times the required output frequency of Npd*Fref, where Npd is the programmable divider modulus and Fref is the reference frequency.

The fixed and programmable dividers provide a set of dividers which are used to tailor the output of the VCOs. The modulus (size) of the divider (eg. /2 or /4) can be fixed or varying. If varying appropriately, the VCOs can be frequency modulated. The varying modulus can be provided by a varying signal or by a suitable combination of varying and fixed signals. For example, the modulus may vary around a fixed point.1

The output of the second VCO 4 is also supplied to a divider 26, which is operable to divide the output of the VCO by 4. The output of the divider is supplied, via a buffer 28, to a power amplifier (not shown) of the mobile station and provides the low band transmitter signal frequency. In a similar manner, the output of the adder 6 is supplied to a divider 22 which operates to divide that summed signal by 2. The divided signal is supplied, via a buffer 24, to the power amplifier of the mobile station. This provides the high band transmitter signal frequency.

In the example embodiment shown in Figure 1, the VCOs 2 and 4 are both tuned to output signals of around 4GHz, so that the high band transmitter signal frequency is 2GHz and the low band 1GHz.

The circuit is also operable to provide the local oscillator (LO) signals to the mobile station receiver (not shown), and this is achieved by supplying the output of the switchable divider 8 to a quadrature splitter and divider 30. The quadrature splitter and divider 30 is operable to produce a signal which is half the frequency of the input signal, and has inphase and quadrature signals for supply to the receiver.

In the examples given, the divider 30 has a single output connection which carries the LO signal at either around 1GHz or around 2GHz. This is possible only if the receiver's mixer has enough bandwidth to handle both these bands. If this is not the case, then respective receivers can be used for the bands, with the LO signal split and routed to those receivers as required.

It is a feature of the invention that the characteristics of the frequency modulation as measured at the input to the programmable divider and also at the output of the circuit (24, 28) are dictated by Npd in exactly the same way as if the VCO was operated at the required final frequency and the fixed dividers 10, 8, 22 and 26 were omitted. Clearly, the frequency modulation measured at the outputs of the VCOs will not be correct - peak deviations of the FM modulation will be twice or four times the required values. It is an advantage of an embodiment of the present invention that the modulated signal at input of programmable divider is defined by variations in Npd produces exactly the same result as for a conventional technique with the VCO equal to the final frequency.

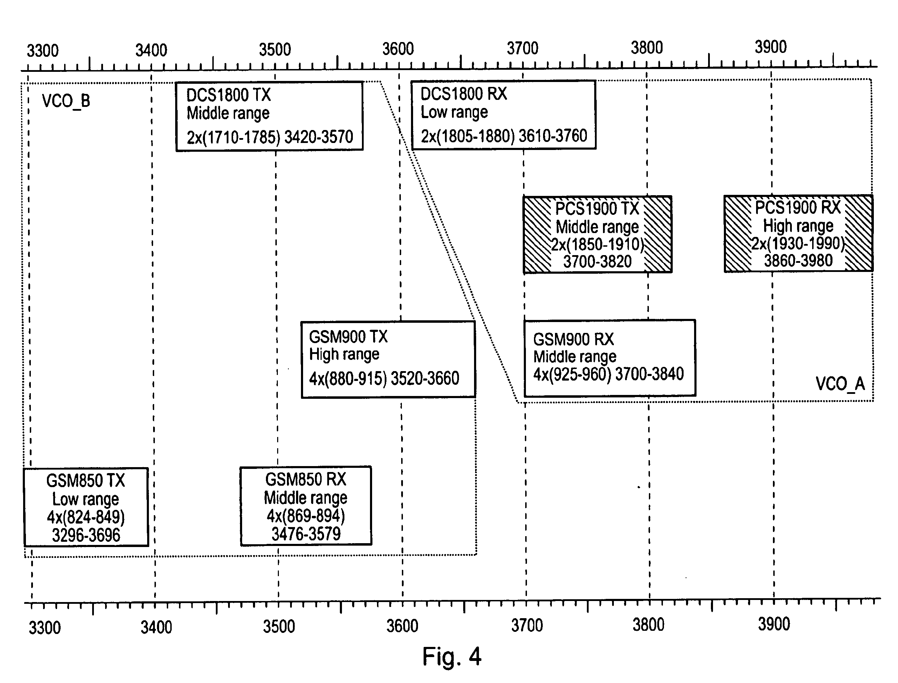

The allocation of bands of operation between VCOA and VCOB can be arranged so as to minimise the tuning range required of each VCO. Figure 4 illustrates that VCO A (2) is used for the reference frequencies for systems around 3600Mhz to 4000Mhz, and VCO B for the range around 3300Mhz to 3650Mhz.

The loop dynamics of the PLL will be affected by the fixed divider in such a way as to reduce the open loop gain by 2 or 4. This is not usually significant though because the tuning sensitivity of the 4GHz VCO is usually approximately twice or 4 times that of a 2 or 1GHz VCO respectively, so the overall loop gain with embodiments of the present invention is not changed significantly.

Embodiments of the present invention can therefore provide two VCOs (2 and 4) that cover the entire required tuning range. The programmable divider of the phase locked loop circuit is presented with a signal at the same frequency as the required frequency (ie. nominally the centre frequency of the GSM channel concerned) so that the circuit behaves as if the VCO was operating at the required frequency instead of a multiple of 2 or 4 times.

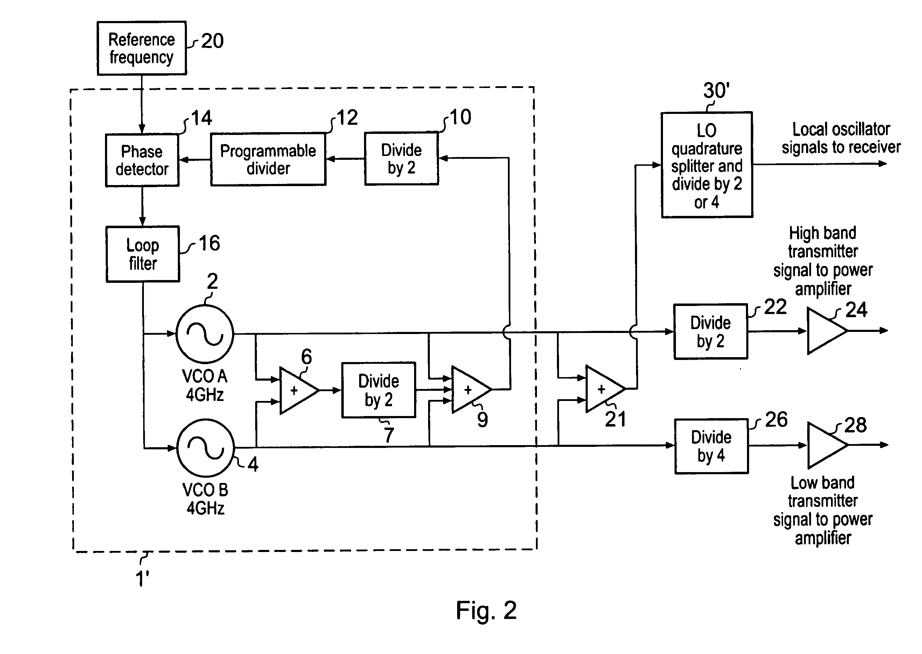

Figure 2 illustrates an alternative circuit layout, in which switchable divider 8 is provided by a fixed divider (÷2) 7 and gates 9 and 21. The gates operate to select an input signal to be transferred to the rest of the circuit. The signal routes from the VCOs 2 and 4 are determined by switching the gates 6, 9, 21, such that the correct VCO is used for the transmit/receive frequencies in use.

The Figure 2 layout gives advantages in terms of circuit layout and size.

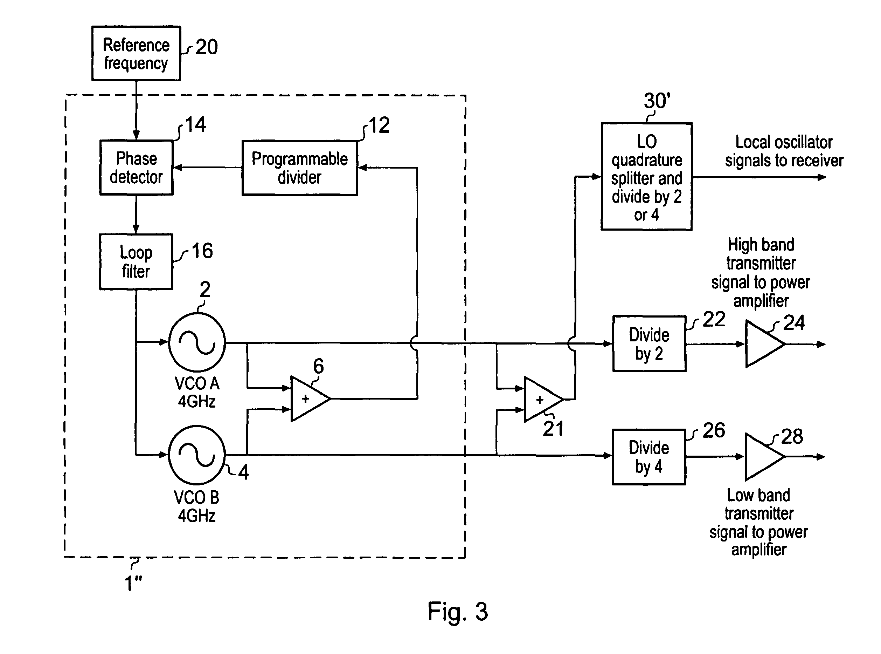

Figure 3 shows a further enhancement, where the PLL actually operates at the VCO frequency, ie. 4GHz. In the case of a fractional-N PLL this allows the resolution of the divided down signals to be higher by a factor 2 or 4.

By using this technique the tuning range of the VCOs is relatively small and easy to implement, and the small size of 4GHz circuits allows significant cost saving relative to the 1GHz VCOs. In addition the frequency of the VCO is different from the final output frequency, which gives benefits in reducing the coupling effects between the output signal and the VCOs. This has the benefit of maintaining control compatibility between different architectures.

## Claims

1. A phase lock loop circuit for a radio frequency transmit and receive apparatus, the circuit comprising:
a first voltage controlled oscillator (2) which is operable to produce a first reference frequency signal,
a second voltage controlled oscillator (4) which is operable to produce a second reference frequency signal,
a switchable set of dividers (7, 8, 10, 12, 22, 26, 30, 30'), connected to receive the first and second reference frequency signals, and operable to produce a set of output reference frequency signals therefrom, a first subset of the set of output reference frequencies being derived from the first reference frequency, and a second subset of the set of output reference frequencies being derived from the second reference frequency, and
a VCO control means (14, 15) connected to receive an external reference signal (20) and a feedback signal, and operable to supply a control voltage to the first and second voltage controlled oscillators (2, 4) in dependence upon received external reference and feedback signals, so as to maintain desired first and second reference frequency signals,
wherein the first and second reference frequency signals are not equal in frequency to the output reference frequency signals in the set of output reference frequency signals, and
wherein the set of dividers (7, 8, 10, 12, 22, 26, 30, 30') comprises:
first divider means (22) for receiving a reference frequency signal, and for producing a high band output reference frequency signal for a transmitter therefrom,
second divider means (26) for receiving the second reference frequency signal and for producing a low band output reference frequency signal for the transmitter,
third divider means (8, 30, 30') for selectively receiving the first or second reference frequency signal and for producing local oscillator output reference frequency signals for a receiver, and
fourth divider means (7, 8, 10, 12) for producing a feedback signal for supply to the VCO control means (14, 16).

2. A circuit as claimed in claim 1, wherein the set of output reference frequency signals have frequencies corresponding to frequencies required for GSM850, GSM900, DCS1800 and PCS1900 mobile telecommunications standards.

3. A circuit as claimed in claim 1 or 2, wherein the first and second voltage controlled oscillators are selectively controlled by a phase locked loop.

4. A circuit as claimed in any one of the claims 1 to 3, wherein the first divider means (22) is connected to receive either the first or second reference frequency signal.

5. A circuit as claimed in any one of claims 1 to 3,
wherein the first divider (22) means is connected to receive the second reference frequency signal.

6. A circuit as claimed in any one of the preceding claims, wherein the set of dividers is operable to vary a modulus value thereof, thereby causing the first and second voltage controlled oscillators to be frequency modulated.

7. A circuit as claimed in claim 6, wherein the modulus value has a fixed portion and a time-varying portion.

## Patentansprüche

1. Phasenverriegelter Schleifenschaltkreis für ein Funkfrequenz-Übertragungs- und Empfangsgerät, wobei der Schaltkreis umfasst:
einen ersten spannungsgesteuerten Oszillator (2), der betriebsfähig ist, ein erstes Referenzfrequenzsignal zu erzeugen,
einen zweiten spannungsgesteuerten Oszillator (4), der betriebsfähig ist, ein zweites Referenzfrequenzsignal zu erzeugen,
einen schaltbaren Satz von Teilern (7, 8, 10, 12, 22, 26, 30, 30'), die verbunden sind, um das erste und zweite Referenzfrequenzsignal zu empfangen und die betriebsfähig sind, einen Satz von Ausgabereferenzfrequenzsignalen aus diesen zu erzeugen, einen ersten Untersatz aus dem Satz von Ausgabereferenzfrequenzen, die aus der ersten Referenzfrequenz abgeleitet werden, und einen zweiten Untersatz aus dem Satz von Ausgabereferenzfrequenzen, die aus der zweiten Referenzfrequenz abgeleitet werden, und
eine VCO-Steuervorrichtung (14, 15), die verbunden ist, um ein externes Referenzsignal (20) und ein Rückkopplungssignal zu empfangen und die betriebsfähig ist, eine Steuerspannung an den ersten und zweiten spannungsgesteuerten Oszillator (2, 4) in Abhängigkeit der empfangenen externen Referenz- und eines Rückkopplungssignale zuzuführen, um so die gewünschten ersten und zweiten Referenzfrequenzsignale aufrecht zu erhalten, und
wobei das erste und zweite Referenzfrequenzsignal in der Frequenz nicht gleich zu den Ausgabereferenzfrequenzsignalen in dem Satz von Ausgabereferenzfrequenzsignalen ist, und
wobei der Satz der Teiler (7, 8, 10, 12, 22, 26, 30, 30') umfasst :
eine erste Teilervorrichtung (22) zum Empfangen eines Referenzfrequenzsignals und zum Herstellen eines Hochband-Ausgabereferenzfrequenzsignals aus diesem für einen Sender,
eine zweite Teilervorrichtung (26) zum Empfangen des zweiten Referenzfrequenzsignals und zum Herstellen eines Niederband-Ausgabereferenzfrequenzsignals für den Sender,
eine dritte Teilervorrichtung (8, 30, 30') zum selektiven Empfangen des ersten oder zweiten Referenzfrequenzsignals und zum Herstellen eines lokalen Oszillator-Ausgabereferenzfrequenzsignals für einen Empfänger, und
eine vierte Teilervorrichtung (7, 8, 10, 12) zum Herstellen eines Rückkopplungssignals zur Zuführung an die VCO-Steuervorrichtung (14, 16).

2. Schaltkreis nach Anspruch 1, wobei der Satz der Ausgabereferenzfrequenzsignale Frequenzen entsprechend zu Frequenzen aufweist, die für GSM850-, GSM900-, DCS1800- und PCS1900-Mobiltelekommunikationsstandards benötigt werden.

3. Schaltkreis nach Anspruch 1 oder 2, wobei der erste und zweite spannungsgesteuerte Oszillator selektiv durch eine phasenverriegelte Schleife gesteuert werden.

4. Schaltkreis nach einem der Ansprüche 1 bis 3, wobei die erste Teilervorrichtung (22) verbunden ist, um entweder das erste oder zweite Referenzfrequenzsignal zu empfangen.

5. Schaltkreis nach einem der Ansprüche 1 bis 3, wobei die erste Teilervorrichtung (22) verbunden ist, um das zweite Referenzfrequenzsignal zu empfangen.

6. Schaltkreis nach einem der vorhergehenden Ansprüche, wobei der Satz von Teilern betriebsfähig ist, einen Modul-Wert von diesen zu verändern, wodurch der erste und zweite spannungsgesteuerte Oszillator veranlasst werden, frequenzmoduliert zu sein.

7. Schaltkreis nach Anspruch 6, wobei der Modul-Wert einen festen Teil und einen zeitlich veränderlichen Teil aufweist.

## Revendications

1. Circuit de boucle d'asservissement de phase pour un appareil d'émission et de réception radiofréquence, le circuit comprenant:
un premier oscillateur commandé par tension (2) qu'on peut faire fonctionner pour produire un premier signal de fréquence de référence,
un second oscillateur commandé par tension (4) qu'on peut faire fonctionner pour produire un second signal de fréquence de référence,
un ensemble de diviseurs pouvant être commutés (7, 8, 10, 12, 22, 26, 30, 30'), connectés pour recevoir les premier et second signaux de fréquence de référence, et qu'on peut faire fonctionner pour produire à partir de ceux-ci un ensemble de signaux de fréquence de référence de sortie, un premier sous-ensemble de l'ensemble de fréquences de référence de sortie étant obtenu à partir de la première fréquence de référence, et un second sous-ensemble de l'ensemble de fréquences de référence de sortie étant obtenu à partir de la seconde fréquence de référence, et
un moyen de commande d'oscillateur commandé par tension (14, 15) connecté pour recevoir un signal de référence externe (20) et un signal de rétroaction, et qu'on peut faire fonctionner pour fournir une tension de commande aux premier et second oscillateurs commandés par tension (2, 4), sous la dépendance de signaux reçus de référence externe et de rétroaction, de façon à maintenir des premier et second signaux de fréquence de référence désirés,
dans lequel les premier et second signaux de fréquence de référence ne sont pas égaux en fréquence aux signaux de fréquence de référence de sortie dans l'ensemble de signaux de fréquence de référence de sortie, et
dans lequel l'ensemble de diviseurs (7, 8, 10, 12, 22, 26, 30, 30') comprend:
un premier moyen diviseur (22) pour recevoir un signal de fréquence de référence, et pour produire à partir de celui-ci un signal de fréquence de référence de sortie de bande haute pour un émetteur,
un second moyen diviseur (26) pour recevoir le second signal de fréquence de référence et pour produire un signal de fréquence de référence de sortie de bande basse pour l'émetteur,
un troisième moyen diviseur (8, 30, 30') pour recevoir sélectivement le premier ou le second signal de fréquence de référence, et pour produire des signaux de fréquence de référence de sortie d'oscillateur local pour un récepteur, et
un quatrième moyen diviseur (7, 8, 10, 12) pour produire un signal de rétroaction pour l'appliquer au moyen de commande d'oscillateur commandé par tension (14, 16).

2. Circuit selon la revendication 1, dans lequel l'ensemble de signaux de fréquence de référence de sortie ont des fréquences correspondant à des fréquences exigées pour les standards de télécommunications mobiles GSM850, GSM900, DCS1800 et PCS1900.

3. Circuit selon la revendication 1 ou 2, dans lequel les premier et second oscillateurs commandés par tension sont commandés sélectivement par une boucle d'asservissement de phase.

4. Circuit selon l'une quelconque des revendications 1 à 3, dans lequel le premier moyen diviseur (22) est connecté pour recevoir le premier ou le second signal de fréquence de référence.

5. Circuit selon l'une quelconque des revendications 1 à 3, dans lequel le premier moyen diviseur (22) est connecté pour recevoir le second signal de fréquence de référence.

6. Circuit selon l'une quelconque des revendications précédentes, dans lequel on peut faire fonctionner l'ensemble de diviseurs pour faire varier une valeur de modulo de ceux-ci, pour ainsi moduler en fréquence les premier et second oscillateurs commandés par tension.

7. Circuit selon la revendication 6, dans lequel la valeur de modulo a une partie fixe et une partie variant au cours du temps.
